# EUROPEAN PATENT APPLICATION

(11) **EP 2 746 846 A1**
(43) Date of publication of application: **25.06.2014**
(21) Application number: 13164452.8
(22) Date of filing: 19.04.2013
(51) Int. Cl.: G02F 1/1343

(54) **Thin film transistor array substrate and method for manufacturing the same, and liquid crystal display device**

(30) Priority: 24.12.2012 CN 201210568430
(71) Applicant: Shanghai Avic Optoelectronics Co. Ltd, Shanghai 201108 (CN)
(72) Inventor: Cao, Zhaokeng, Shanghai Shanghai 201108 (CN); Zhao, Yujie, Shanghai Shanghai 201108 (CN)
(74) Representative: Prinz & Partner

(57) **Abstract**

The present invention provides a thin film transistor array substrate and a method for manufacturing the same, and a liquid crystal display device. The thin film transistor array substrate includes: data line formed on a transparent substrate, a first transparent electrode located in a same layer as the data line, an insulating layer covering the data line and the first transparent electrode, and a second transparent electrode located on the insulating layer; the second transparent electrode includes a first transparent sub-electrode and a second transparent sub-electrode; the width of the first transparent sub-electrode is smaller than the width of the first transparent electrode; the width of the second transparent sub-electrode is greater than the width of the data line.

## Description

### FIELD OF THE INVENTION

The present invention relates to the field of liquid crystal display, and in particular to a thin film transistor array substrate and a method for manufacturing the same, and a liquid crystal display device.

### BACKGROUND OF THE INVENTION

A thin film transistor liquid crystal display (TFT-LCD) is a kind of liquid crystal display, and is an active matrix type LCD. The thin film transistor liquid crystal display has features such as low radiation, low thickness and low power consumption, and is widely applied in various fields.

For the liquid crystal display, there is a problem that image contrast reduces while a viewing angle increases. Therefore there is a viewing angle defect in the liquid crystal display. In order to achieve wide viewing angle display, both an in-plane switch (IPS) type liquid crystal display panel and a fringe field switching (FFS) type liquid crystal display panel are developed. In the field of liquid crystal, FFS is a wide viewing angle technology developed to be applied in a large size panel and high definition desktop display and liquid crystal television. In the FFS technology, a transparent ITO electrode is used instead of an opaque metal electrode in the IPS. The width of the electrode and the distance between the electrodes are reduced. The liquid crystal molecules both between the electrodes and directly above the electrodes may oriented to rotate in the plane direction (parallel to a substrate) under a fringe electric field generated by electrodes between pixels in a same plane. Therefore light transmittance of a liquid crystal layer is increased. The FFS technology solves a problem of low light transmittance of the conventional IPS technology, so as to achieve high light transmittance with a wide viewing angle.

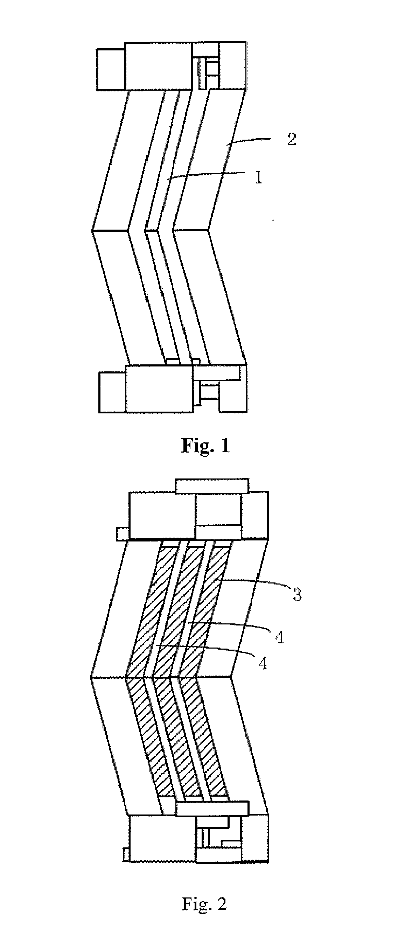

Referring to Fig.1, Fig.1 is a structural schematic diagram of electrodes in the existing IPS type liquid crystal display panel. In the IPS type liquid crystal display panel, a horizontal electric field driving liquid crystal is formed between a pixel electrode 1 and a common electrode 2. A required driving voltage is also needed to increase while a distance between the pixel electrode 1 and the common electrode 2 increases. Sometimes the required driving voltage may be greater than a voltage that can be supplied by a driving chip. In such case, the strength of the horizontal electric field formed by the driving chip is too weak to drive the liquid crystals, leading to the poor display.

Referring to Fig.2, Fig.2 is a structural schematic diagram of electrodes in the existing FFS type liquid crystal display panel. In the FFS type liquid crystal display panel, a pixel electrode 3 is located in an aperture region of a pixel unit in an entire plane structure, and forms a fringe electric field with a common electrode 4 above the pixel electrode 3. Although the pixel electrode 3 is a transparent electrode, the pixel electrode still absorbs 5% of transmitting light, leading to reduction in the light transmittance of the panel.

### SUMMARY OF THE INVENTION

According to the present invention, it is provided a thin film transistor array substrate, in a liquid crystal display panel using the thin film transistor array substrate, a stronger horizontal electric field without a very large driving voltage may be formed, so as a liquid crystal display with a smaller color deflection, a higher aperture ratio and better light transmittance may be obtained. The thin film transistor array substrate according to the present invention includes:

a transparent substrate;

a data line formed on the transparent substrate;

a first transparent electrode located in a same layer as the data line;

an insulating layer covering the data line and the first transparent electrode; and

a second transparent electrode located on the insulating layer; wherein the second transparent electrode includes a first transparent sub-electrode and a second transparent sub-electrode; the first transparent sub-electrode is located above the first transparent electrode, and the width of the first transparent sub-electrode is smaller than the width of the first transparent electrode; the second transparent sub-electrode is located above the data line, and the width of the second transparent sub-electrode is greater than the width of the data line;

a horizontal electric field is formed between the first transparent electrode and the second transparent electrode if the thin film transistor array substrate is in operation.

Optionally, the second transparent electrode includes at least two first transparent sub-electrodes; the second transparent electrode further includes at least one third transparent sub-electrode in electrically connection, the third transparent sub-electrode is located between the two adjacent first transparent sub-electrodes.

Optionally, a center of the first transparent sub-electrode overlaps with a center of the first transparent electrode in the normal direction of the transparent substrate.

Optionally, the first transparent electrode is a pixel electrode, and the second transparent electrode is a common electrode.

Optionally, the first transparent electrode is electrically connected to a drain electrode of a thin film transistor, the data line is electrically connected to a source electrode of a thin film transistor, and a gate electrode of the thin film transistor is electrically connected to a scanning line.

The present invention further provides a liquid crystal display device, including:

the thin film transistor array substrate described above;

a color filter substrate disposed opposite to the array substrate; and

a liquid crystal layer filled between the thin film transistor array substrate and the color filter substrate.

The present invention further provides a method for manufacturing a thin film transistor array substrate, including:

providing a transparent substrate;

forming a first transparent electrode and data line on the transparent substrate;

forming an insulating layer which covers the first transparent electrode and the data Line; and

forming a second transparent electrode on the insulating layer, wherein the second transparent electrode includes a first transparent sub-electrode and a second transparent sub-electrode; the first transparent sub-electrode is located above the first transparent electrode, and the width of the first transparent sub-electrode is smaller than the width of the first transparent electrode; the second transparent sub-electrode is located above the data line, and the width of the second transparent sub-electrode is greater than the width of the data line.

Optionally, the second transparent electrode includes at least two first transparent sub-electrodes; the second transparent electrode further includes at least one third transparent sub-electrode, the third transparent sub-electrode is located between the two adjacent first transparent sub-electrodes.

Optionally, a center of the first transparent sub-electrode overlaps with a center of the first transparent electrode in the normal direction of the transparent substrate.

Optionally, the first transparent electrode is a pixel electrode, and the second transparent electrode is a common electrode.

Optionally, before forming the first transparent electrode and the data line on the transparent substrate, following steps are performed:

forming a gate electrode of a thin film transistor and a scanning line on the transparent substrate;

forming a gate insulating layer which covers the gate electrode and the scanning line; and

preferably, forming a semiconductor layer on the gate insulating layer, or forming a semiconductor layer and an ohmic contact layer on the semiconductor layer on the gate insulating layer.

Optionally, a source electrode and a drain electrode of the thin film transistor are formed while the data line is formed, the source electrode and the drain electrode contact the semiconductor layer, the first transparent electrode is electrically connected to the drain electrode of the thin film transistor, and the data line is electrically connected to the source electrode of the thin film transistor.

In comparison with the existing art, the present invention has advantages as below:

in the thin film transistor array substrate according to the present invention, a stronger horizontal electric field is generated even if a smaller driving voltage is applied between the second transparent electrode and the first transparent electrode, and interferences between electrodes are avoided. Therefore liquid crystals are better driven by the horizontal electric field, a liquid crystal display with a large viewing angle and no color difference when being viewed from various viewing angles is obtained, and the image response of the display device is quick and sensitive;

the thin film transistor array substrate according to the present invention only needs two layers of transparent electrodes to drive the liquid crystal layer, and therefore the light transmittance of the display device is increased.

### BRIEF DESCRIPTION OF THE DRAWINGS

Fig.1 is a schematic diagram of a pixel electrode of an existing IPS type liquid crystal display panel;

Fig.2 is a schematic diagram of a pixel electrode of an existing FFS type liquid crystal display panel;

Fig.3 is a schematic diagram of a liquid crystal display device according to a first embodiment;

Fig.4 is a schematic diagram of a liquid crystal display device according to a second embodiment;

Fig.5 is a schematic top view of a thin film transistor array substrate of the liquid crystal display device according to the second embodiment; and

Fig.6 to Fig.9 are schematic diagrams of various steps of a method for manufacturing a thin film transistor array substrate according to a third embodiment.

### DETAILED DESCRIPTION OF THE INVENTION

### A First Embodiment

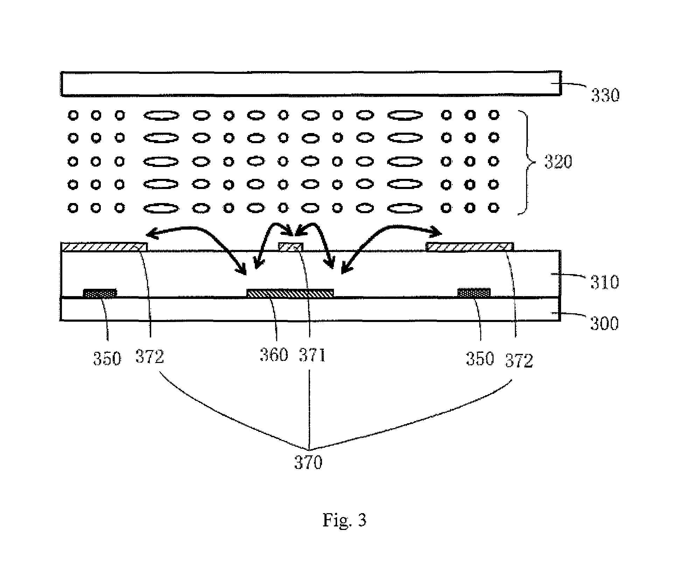

According to the present embodiment, it is provided a liquid crystal display device and a thin film transistor array substrate included in the liquid crystal display device, as shown in Fig.3. The liquid crystal display device includes the thin film transistor array substrate and a color filter substrate 330 which is disposed opposite to the array substrate. A liquid crystal layer 320 is filled between the thin film transistor array substrate and the color filter substrate 330. The drawings for embodiments of the present invention do not show the proportion and size of a substantial object and are only schematic diagrams for illustrating technical solutions of the present invention. For example, the specific structure of the color filter substrate 330 is omitted in the accompanying drawings.

Referring to Fig.3, in the present embodiment, the thin film transistor array substrate includes a transparent substrate 300. A data line 350 and a first transparent electrode 360 are formed on the transparent substrate 300. Preferably, in the present embodiment, the first transparent electrode 360 is a pixel electrode. The thin film transistor array substrate further includes an insulating layer 310 which may be made of a transparent insulating material. The insulating layer 310 covers the data line 350 and the first transparent electrode 360. A second transparent electrode 370 is disposed on the insulating layer 310. Preferably, in the present embodiment, the second transparent electrode 370 is a common electrode and includes a first transparent sub-electrode 371 and a second transparent sub-electrode 372.

In the present embodiment, the first transparent sub-electrode 371 of the second transparent electrode 370 is located above the first transparent electrode 360. In fact, in a more preferable solution of the present embodiment, the first transparent sub-electrode 371 is disposed in such a way that the center thereof overlaps with the center of the first transparent electrode 360 in the normal direction of the transparent substrate 300. It may be understood that the first transparent sub-electrode 371 and the first transparent electrode 360 are symmetrical at left and right with respect to a same vertical line (not shown) in Fig.3. Furthermore, the width of the first transparent sub-electrode 371 is smaller than the width of the first transparent electrode 360. The second transparent sub-electrode 372 of the second transparent electrode 370 is located above the data line 350, and the width of the second transparent sub-electrodes 372 is greater than the width of the data line 350.

In a case of the above configuration, when the thin film transistor array substrate according to the present embodiment is in operation, if a certain voltage is applied between the first transparent electrode 360 and the second transparent electrode 370, specifically, if voltages of opposite polarities are respectively applied to the two electrodes(i.e. one of the first transparent electrode 360 and the second transparent electrode 370 is applied with a positive voltage, the other is applied with a negative voltage), a horizontal electric field are formed between the first transparent electrode 360 and the second transparent electrode 370.

Specifically, as shown by curves with two-way arrows in Fig.3, a stronger horizontal electric field is formed between the first transparent sub-electrode 371 and the first transparent electrode 360. This is because the first transparent sub-electrode 371 is disposed in such a way that the center thereof overlaps with the center of the first transparent electrode 360 in the normal direction of the transparent substrate 300, and the width of the first transparent sub-electrode 371 is smaller than the width of the first transparent electrode 360. Thereby, intensive electric field lines facing the liquid crystal layer 320 which is over the first transparent sub-electrode 371 is generated by means of the first transparent sub-electrode 371 and the first transparent electrode 360 which is under the first transparent sub-electrode 371. That is to say, a stronger horizontal electric field is formed between the first transparent sub-electrode 371 and the first transparent electrode 360. Moreover, since the width of the first transparent sub-electrode 371 is smaller than the width of the first transparent electrode 360, the first transparent sub-electrode 371 may not shield the first transparent electrode 360 which is under the first transparent sub-electrode 371. Therefore another horizontal electric field facing the liquid crystal layer 320 is also formed between the second transparent sub-electrode 372 and the first transparent electrode 360. Since the second transparent sub-electrode 372 is located above the data line 350, and the width of the second transparent sub-electrode 372 is greater than the width of the data line 350, the data lines 350 may be shielded by the second transparent sub-electrode 372, thus the horizontal electric field formed between the first transparent electrode 360 and the second transparent electrode 370 may not be interfered. Therefore the horizontal electric field is stable and has high intensity and is applicable for better driving liquid crystal molecules in the liquid crystal layer 320.

It should be noted that, although not shown in Fig.3, according to the present embodiment, in the above mentioned liquid crystal display including the thin film transistor array substrate, thin film transistors are formed on the transparent substrate 300 of the thin film transistor array substrate. The first transparent electrode 360 is electrically connected to a drain electrode of the thin film transistor, and the data line 350 is electrically connected to a source electrode of the thin film transistor. The thin film transistor array substrate further includes scanning line (not shown in Fig.3), and a gate electrode of the thin film transistor is electrically connected to the scanning line.

The thin film transistor array substrate according to the present embodiment has advantages of both the IPS type array substrate and the FFS type array substrate. That is by using the horizontal electric field to control the liquid crystal to rotate, a liquid crystal display with a large viewing angle and no color difference when being viewed from various viewing angles is achieved, and the image response of the liquid crystal display is quick and sensitive. According to the thin film transistor array substrate of the present embodiment, a problem for the IPS type array substrate that a weak electric field easily occurs is avoided, a problem of low light transmittance for the FFS type array substrate is also avoided, and the thin film transistor array substrate may be regarded as a hybrid enhanced array substrate.

### A Second Embodiment

According to the present embodiment, it is provided another liquid crystal display device and its thin film transistor array substrate. The liquid crystal display device includes all of the structures in the first embodiment. Therefore most of the structures of the liquid crystal display device and its thin film transistor array substrate according to the present embodiment are the same as the structures according to the first embodiment. For the features of the corresponding structure, the corresponding content in the first embodiment may be referred to.

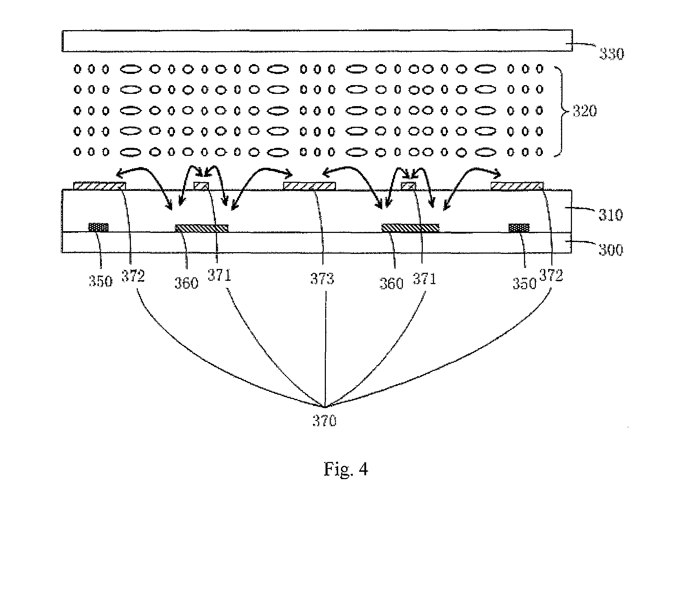

Referring to Fig.4, a difference between the liquid crystal display device and the thin film transistor array substrate of the liquid crystal display device according to the present embodiment and those according to the first embodiment lies in that, in the present embodiment, the second transparent electrode 370 of the thin film transistor array substrate further includes a third transparent sub-electrode 373, the third transparent sub-electrode 373 is located between the two adjacent first transparent sub-electrodes 371. Since the third transparent sub-electrode 373 is disposed between the two adjacent first transparent sub-electrodes 371 in the present embodiment, the third transparent sub-electrode 373 may form horizontal electric fields with the first transparent electrodes 360 under the first transparent sub-electrodes 371 which are at the left and right sides of the third transparent sub-electrode 373 respectively. Therefore the horizontal electric field lines can become more intensive, the horizontal electric field formed from the thin film transistor array substrate becomes stronger, and the display performance of the liquid crystal display according to the present embodiment is further improved.

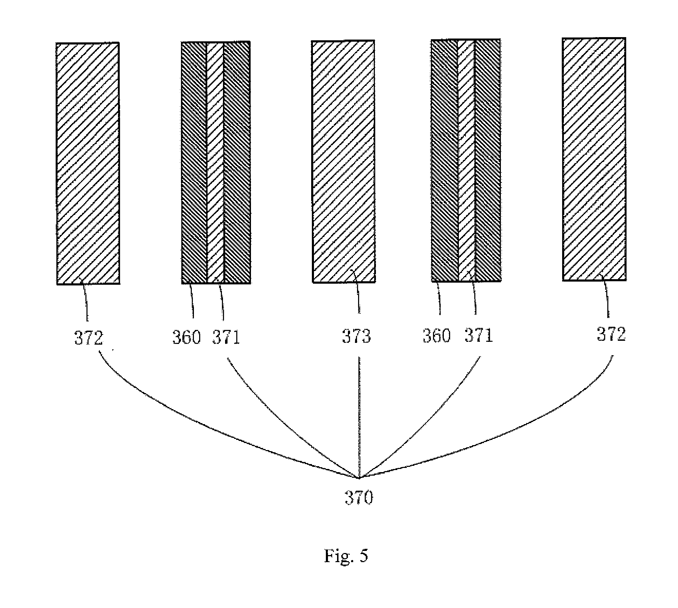

Referring to Fig.5, Fig.5 is a schematic top view of the thin film transistor array substrate in the liquid crystal display device according to the second embodiment. In Fig.5, structures of the transparent substrate 300, the insulating layer 310 and other layers of the thin film transistor array substrate are omitted, and only the first transparent electrodes 360 and the second transparent electrode 370 are shown, so that the positional relationship between the first transparent electrodes 360 and the second transparent electrode 370 is shown clearly. It can be seen apparently from the figure that, in the present embodiment, the center of the first transparent sub-electrode 371 of the second transparent electrode 370 overlaps with the center of the first transparent electrode 360 in the normal direction of the transparent substrate 300, and the width of the first transparent sub-electrode 371 is smaller than the width of the first transparent electrode 360. The width of the second transparent sub-electrode 372 of the second transparent electrode 370 is greater than the width of the data line 350 (therefore the data line 350 is covered under the second transparent sub-electrode 372 and not shown in the figure). A third transparent sub-electrode 373 is further formed between the two first transparent sub-electrodes 371. It should be noted that, in other embodiments of the present invention, the width of the third transparent sub-electrode 373 may be arbitrary, and in other cases, more than one third transparent sub-electrode 373 may be disposed between the two first transparent sub-electrodes 371, depending on the an actual requirement.

### A Third Embodiment

According to the present embodiment, it is provided a method for manufacturing a thin film transistor array substrate. The method including Step S1 to Step S4.

Step SI: providing a transparent substrate.

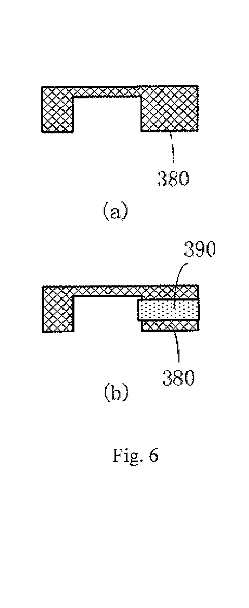

Preferably, referring to Fig.6, after the step of providing the transparent substrate, a gate electrode (not marked) of a thin film transistor and a scanning line 380 may be formed on the provided transparent substrate (not shown in the figure). The gate electrode is connected to the scanning line 380, or preferably the gate electrode and the scanning line may be formed integrally with a same material in a same step. For example, for the scanning line 380 shown in Fig.6 (a), a downwardly protruding portion of the scanning line 380 is served as the gate electrode. Then a gate insulating layer (not shown in the figure) is formed to cover the gate electrode and the scanning line 380. Then, as shown in Fig.6 (b), a semiconductor layer 390 (also known as an active layer) is formed on the gate insulating layer (the semiconductor layer 390 and the gate electrode are insulated from each other by the gate insulating layer). More preferably, an ohmic contact layer (not shown in the figure) may be further formed on the semiconductor layer 390 so as to reduce contact resistances between a source electrode of the thin film transistor formed subsequently and the semiconductor layer 390, and between a drain electrode of the thin film transistor formed subsequently and the semiconductor layer 390.

Step S2: forming a first transparent electrode and data line on the transparent substrate.

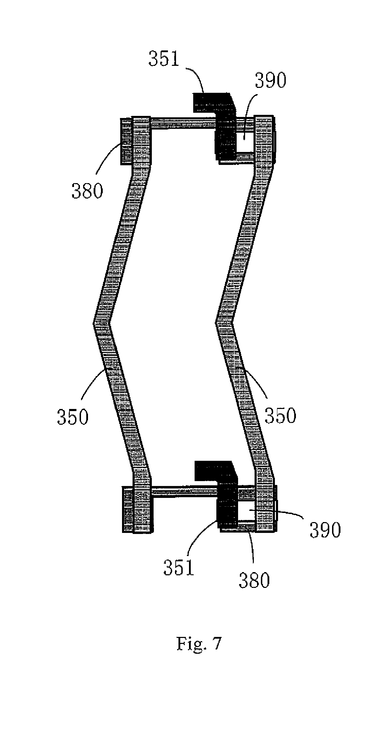

In the present embodiment, as shown in Fig.7, the data line 350, the source electrode of the thin film transistor, and the drain electrode 351 of the thin film transistor which is formed simultaneously with the source electrode are formed firstly. The data line 350, the source electrode and the drain electrode 351 may be formed simultaneously with a same material in a same process step. For example, the data line 350 and the drain electrode 351 may be formed simultaneously with a same depositing metal layer through a same exposure and development process. The data line 350 is electrically connected to the source electrode of the thin film transistor and is preferably formed integrally with the source electrode of the thin film transistor. In particularly, in the preferable embodiment described above, the source electrode and the drain electrode 351 contact the semiconductor layers 390. More preferably, the source electrode and the drain electrode 351 may contact the semiconductor layer 390 via the ohmic contact layer.

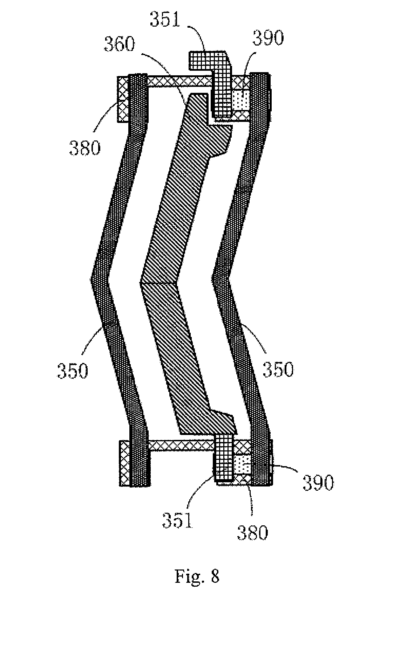

Then a first transparent electrode 360 is formed on the transparent substrate by a lithography process, as shown in Fig.8. In the present embodiment, the first transparent electrode 360 is preferably a pixel electrode, and the first transparent electrode 360 is electrically connected to the drain electrode 351.

Step S3: forming an insulating layer which covers the first transparent electrode and the data line.

In the present embodiment, after the first transparent electrode 360 is formed, an insulating layer (not shown in Fig.8, referring to the insulating layer 310 in Fig.3 or Fig.4) is formed on the transparent substrate. The insulating layer covers the first transparent electrode 360, the data lines 350, and other structures formed on the transparent substrate. Various depositing processes such as a physical vapor deposition (PVD) process, a chemical vapor deposition (CVD) process or an atomic layer deposition (ALD) process may be adopted to form the insulating layer. Various deposition processes may be performed according to the existing technical methods, and are not described any more herein.

Step S4: forming a second transparent electrode on the insulating layer.

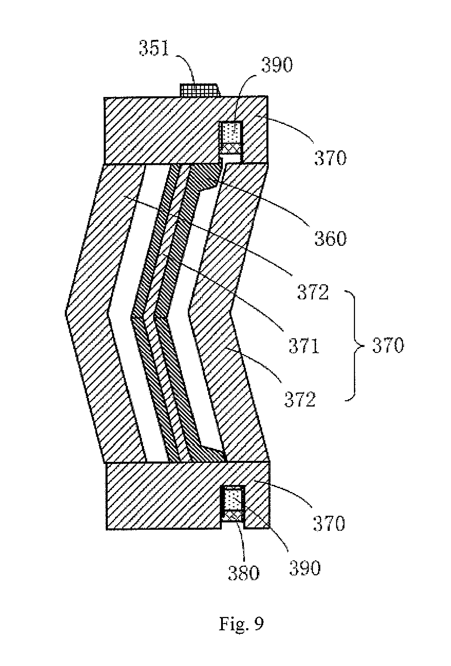

Preferably, in the present embodiment, the second transparent electrode 370 formed on the insulating layer is preferably a common electrode, as shown in Fig.9. It can be seen from Fig.9 that, in the present embodiment, the second transparent electrode 370 includes a first transparent sub-electrode 371 and a second transparent sub-electrode 372. The first transparent sub-electrode 371 is located above the first transparent electrode 360, and the width of the first transparent sub-electrode 371 is smaller than the width of the first transparent electrode 360. The second transparent sub-electrode 372 is located above the data line, and width of the second transparent sub-electrode 372 is greater than the width of the data line. According to the present embodiment, during the process, the first transparent sub-electrode 371 is preferably manufactured in such a way that the center thereof overlaps with the center of the first transparent electrode 360 in the normal direction of the transparent substrate. Through a design of a mask used in forming the first transparent electrode 360 and the first transparent sub-electrode 371, it can be achieved that the center of the formed first transparent sub-electrode 371 overlaps with the center of the first transparent electrode 360 in the normal direction of the transparent substrate.

More preferably, in another embodiment of the present invention, the second transparent electrode 370 formed in Step S4 includes at least two first transparent sub-electrodes 371. The second transparent electrode 370 may further includes at least one third transparent sub-electrode. The third transparent sub-electrode may be located between the two adjacent first transparent sub-electrodes 371. The third transparent sub-electrode is electrically connected to at least one of the first transparent sub-electrode 371 and the second transparent sub-electrode 372.

In the present embodiment, through Steps S1 to S4, the thin film transistor array substrate is manufactured and obtained, as shown in Fig.9. As for the structure of the thin film transistor array substrate, the corresponding content in the first embodiment may also be referred to.

It should be noted that, in the present embodiment, only the method for manufacturing the bottom gate type thin film transistor is described as an example. However, it is known by those skilled in the art that the method may also be used to manufacture a top gate type thin film transistor. For example, specifically, in Step S1, a semiconductor layer is first formed on the provided substrate (or more preferably, a buffer layer is first formed before the semiconductor layer is formed), then a first insulating layer is formed on the semiconductor layer to cover the semiconductor layer, and then a gate electrode of a thin film transistor is formed on the first insulating layer and a second insulating layer which covers the gate electrode is formed on the gate electrode. The source electrode and the drain electrode of the thin film transistor formed subsequently in Step S2 are electrically connected to the semiconductor layer through via holes formed on the first insulating layer and the second insulating layer.

Since difference between the method for manufacturing the top gate type thin film transistor and the method for manufacturing the bottom gate type thin film transistor in the present embodiment only lies in a sequence of forming the gate electrode of the thin film transistor and the semiconductor layer in Step S1, and no change occurs in the subsequent steps, only the method for manufacturing the top gate type thin film transistor is described briefly here, and the same steps are not described any more. Furthermore, since the manufacturing process and corresponding structure changes of the top gate type thin film transistor are technologies well known in the art, those skilled in the art may reasonably obtain manufacturing methods and structures of various top gate type thin film transistors in conjunction with the embodiments in the present invention on the basis of the existing known technologies, which will not descried any more herein either.

The embodiments of the present invention are described herein in a progressive manner, with the emphasis of each of the embodiments on the difference between it and the other embodiments; hence, for the same or similar parts between the embodiments, one can refer to the other embodiments.

The embodiments described above are only specific embodiments of the present invention, so that those skilled in the art may better understand the spirit of the present invention. However, the scope of protection of the present invention does not limited by the detailed descriptions of the specific embodiments. Modifications can be made to the specific embodiments of the present invention by any of those skilled in the art in light of the spirit of the present invention, without deviation from the scope of protection of the present invention.

## Claims

1. A thin film transistor array substrate, comprising:
a transparent substrate;
a data line formed on the transparent substrate;
a first transparent electrode located in a same layer as the data line;
an insulating layer covering the data line and the first transparent electrode; and
a second transparent electrode located on the insulating layer, wherein the second transparent electrode comprises a first transparent sub-electrode and a second transparent sub-electrode; the first transparent sub-electrode is located above the first transparent electrode, and the width of the first transparent sub-electrode is smaller than the width of the first transparent electrode; the second transparent sub-electrode is located above the data line, and the width of the second transparent sub-electrode is greater than the width of the data line;
a horizontal electric field is formed between the first transparent electrode and the second transparent electrode if the thin film transistor array substrate is in operation.

2. The thin film transistor array substrate according to claim 1, wherein the second transparent electrode comprises at least two first transparent sub-electrodes; the second transparent electrode further comprises at least one third transparent sub-electrode, the third transparent sub-electrode is located between the two adjacent first transparent sub-electrodes.

3. The thin film transistor array substrate according to claim 1, wherein a center of the first transparent sub-electrode overlaps with a center of the first transparent electrode in the normal direction of the transparent substrate.

4. The thin film transistor array substrate according to claim 1, wherein the first transparent electrode is a pixel electrode, and the second transparent electrode is a common electrode.

5. The thin film transistor array substrate according to claim 1, wherein the first transparent electrode is electrically connected to a drain electrode of a thin flm transistor, the data line is electrically connected to a source electrode of the thin film transistor, and a gate electrode of the thin film transistor is electrically connected to a scanning line.

6. A liquid crystal display device, comprising:
the thin film transistor array substrate according to any one of claims 1 to 5;
a color filter substrate disposed opposite to the array substrate; and
a liquid crystal layer filled between the thin film transistor array substrate and the color filter substrate.

7. A method for manufacturing a thin film transistor array substrate, comprising:
providing a transparent substrate;
forming a first transparent electrode and data line on the transparent substrate;
forming an insulating layer which covers the first transparent electrode and the data line;
and
forming a second transparent electrode on the insulating layer, wherein the second transparent electrode comprises a first transparent sub-electrode and a second transparent sub-electrode; the first transparent sub-electrode is located above the first transparent electrode, and the width of the first transparent sub-electrode is smaller than the width of the first transparent electrode; the second transparent sub-electrode is located above the data line, and the width of the second transparent sub-electrode is greater than the width of the data line.

8. The method for manufacturing the thin film transistor array substrate according to claim 7, wherein the second transparent electrode comprises at least two first transparent sub-electrodes; the second transparent electrode further comprises at least one third transparent sub-electrode, the third transparent sub-electrode is located between the two adjacent first transparent sub-electrodes.

9. The method for manufacturing the thin film transistor array substrate according to claim 7, wherein a center of the first transparent sub-electrode overlaps with a center of the first transparent electrode in the normal direction of the transparent substrate.

10. The method for manufacturing the thin film transistor array substrate according to claim 7, wherein the first transparent electrode is a pixel electrode, and the second transparent electrode is a common electrode.

11. The method for manufacturing the thin film transistor array substrate according to claim 7, wherein before forming the first transparent electrode and the data line on the transparent substrate, following steps are performed:
forming a gate electrode of a thin film transistor and a scanning line on the transparent substrate;
forming a gate insulating layer which covers the gate electrode and the scanning line;
and
forming a semiconductor layer on the gate insulating layer, or forming a semiconductor layer and an ohmic contact layer on the semiconductor layer on the gate insulating layer.

12. The method for manufacturing the thin film transistor array substrate according to claim 11, wherein a source electrode and a drain electrode of the thin film transistor are formed while the data line is formed, the source electrode and the drain electrode contact the semiconductor layer, the first transparent electrode is electrically connected to the drain electrode of the thin film transistor, and the data line is electrically connected to the source electrode of the thin film transistor.
